(19) Europäisches Patentamt / European Patent Office / Office européen des brevets

(11) **EP 2 849 964 B1**

(12) **FASCICULE DE BREVET EUROPEEN**

(45) Date de publication et mention
de la délivrance du brevet:
**29.06.2016 Bulletin 2016/26**

(21) Numéro de dépôt: **13727298.5**

(22) Date de dépôt: **16.05.2013**

(51) Int Cl.:
***B60L 3/12*** *(2006.01)* ***G01R 27/20*** *(2006.01)*

(86) Numéro de dépôt international:
**PCT/FR2013/051065**

(87) Numéro de publication internationale:
**WO 2013/171431 (21.11.2013 Gazette 2013/47)**

(54) **SYSTÈME ET PROCÉDÉ DE CHARGE SÉCURISÉE D'UNE BATTERIE DE VÉHICULE AUTOMOBILE**

SYSTEM UND VERFAHREN ZUR SICHEREN AUFLADUNG EINER KRAFTFAHRZEUGBATTERIE

SYSTEM AND METHOD FOR SECURE CHARGING OF A MOTOR VEHICLE BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.05.2012 FR 1254514**

(43) Date de publication de la demande:
**25.03.2015 Bulletin 2015/13**

(73) Titulaire: **Renault S.A.S.**
**92100 Boulogne-Billancourt (FR)**

(72) Inventeur: **MERIENNE, Ludovic**
**F-91190 Gif Sur Yvette (FR)**

(56) Documents cités:
**WO-A2-2011/112510 CN-U- 201 508 392**

**Description**

L'invention concerne la sécurité d'un utilisateur d'un dispositif embarqué de charge d'une batterie d'un véhicule automobile, et plus particulièrement l'estimation de la qualité de la terre du réseau d'alimentation couplé au dispositif de charge de la batterie du véhicule automobile.

Lors de la charge d'une batterie d'un véhicule automobile électrique, des courants intenses transitent du réseau d'alimentation vers la batterie du véhicule. Pour pouvoir charger correctement le véhicule, ces courants sont hachés de manière à respecter les contraintes du réseau d'alimentation.

Le hachage des courants électriques entraîne l'apparition de courants de fuite qui doivent être évacués par la prise de terre du réseau d'alimentation. Cette prise de terre est reliée au châssis du véhicule et offre donc un chemin à tous les courants parasites.

Pour assurer une charge en toute sécurité, il faut s'assurer que la liaison à la terre soit de bonne qualité, c'est-à-dire que la résistance équivalente du chemin de terre soit faible devant la résistance qu'offrirait un être humain touchant le châssis du véhicule automobile. Sans cette liaison à la terre, un phénomène de courant de toucher peut apparaître. Si un homme venait à toucher le châssis du véhicule, c'est son corps qui établirait la liaison entre le chargeur et la terre et c'est donc par lui que passeraient tous les courants de fuites qui seraient potentiellement dangereux, sans aucun dispositif de contrôle ajouté.

Une terre de mauvaise qualité, c'est-à-dire de résistance équivalente à celle d'un corps humain, permet également le passage d'une partie des courants de fuite par le corps de l'individu. En effet, si un individu venait à toucher le châssis du véhicule en charge, dans ce cas, les courants de fuite auraient deux chemins parallèles de même résistance, donc la moitié des courants de fuite pourraient passer par l'individu pour revenir à la terre.

Pour assurer qu'aucun courant de toucher ne puisse apparaître, il faut s'assurer que la valeur de la résistance de liaison à la terre est inférieure à un certain seuil avant de charger la batterie du véhicule automobile.

Pour pouvoir estimer la résistance entre la terre et le neutre du réseau d'alimentation, il est possible d'injecter des impulsions de courant directement dans le chemin de terre et rebouclant par le neutre du réseau et de mesurer la tension entre le neutre et la terre.

Dans le cas idéal, le courant injecté dans la terre est mesuré ainsi que la tension qui est l'image du courant injecté d'après la loi d'Ohm. La valeur de la résistance est alors obtenue en divisant la tension mesurée par le courant mesuré.

Malheureusement, il est impossible d'avoir des résultats corrects aussi simplement car la tension entre le neutre et la terre est très perturbée.

Une première partie des perturbations peut provenir des courants de fuite mentionnés plus haut. Ces courants passant par la terre également, ils viennent perturber la mesure de la tension entre le neutre et la terre.

Certaines données sont connues sur l'ensemble de ces perturbations. En basse fréquence, notamment pour des fréquences inférieure à 1 kHz, ces perturbations sont générées aux harmoniques du réseau d'alimentation, soit par exemple 50 Hz, 100 Hz, etc., et possèdent une amplitude maximale de 7 V pour la tension efficace et de 6,6 mA pour les courants. Ces niveaux de perturbation sont définis par les normes EDF. Pour les fréquences supérieures, les normes EDF prévoient des amplitudes de courants de perturbation variant de manière continue entre 6,6 mA à 1,5 kHz et 66 mA à 15 kHz, l'amplitude du courant restant à 66 mA jusqu'à 150 kHz.

Enfin, une dernière contrainte résulte du fait qu'on ne peut pas envoyer n'importe quel courant dans la terre. Il ne faut surtout pas faire disjoncter le réseau sur lequel le circuit est branché. Il est donc impossible d'envoyer des impulsions d'amplitude trop importante et/ou de durée trop longue.

L'enjeu est donc de réussir à estimer la résistance de terre malgré toutes les sources d'erreur, en respectant les contraintes imposées par l'obligation de devoir embarquer le système sur un véhicule automobile dont les processeurs fonctionnent à une fréquence maximale de 10 kHz.

Une seconde partie des perturbations, représentant une partie importante des perturbations, peut provenir des bornes de charge ou d'un autre véhicule automobile en charge car les organes de cet autre véhicule automobile viennent connecter une capacité parasite entre la terre et le neutre du réseau d'alimentation ce qui peut fausser la mesure de la résistance de la terre de manière importante.

Dans le cas, par exemple, où la terre du réseau n'est pas connectée, le seul chemin pour le courant est fourni par la capacité parasitaire. Les impulsions de courant injectées dans la terre pour mesurer la résistance de la terre vont alors charger la capacité parasite.

Dans un cas, par exemple, où un dispositif de charge est connecté à une capacité parasite de $1\mu F$, l'injection d'une impulsion de courant de 20 mA d'amplitude et d'une durée d'impulsion de 1 ms entraînera une tension de charge de la capacité de 5 V environ ce qui est équivalent à une résistance de 250 Ohms. Cette résistance fictive mise en parallèle à la vraie résistance de terre fausse alors le calcul, en diminuant notamment la valeur obtenue pour la résistance de terre estimée. Une erreur dans l'estimation peut être dangereuse quant à la sécurité des utilisateurs.

Il existe dans le commerce des appareils effectuant une estimation de la résistance de la terre. Ces appareils possèdent une puissance de calcul bien supérieure à celle disponible sur un véhicule automobile et ont un prix trop élevé pour envisager d'en mettre sur chaque véhicule automobile.

Cependant, ces appareils ne sont pas configurés dans un but de gérer la sécurité d'un individu. En effet, ils ne sont configurés que pour donner l'information sur la valeur de la résistance de terre.

La demande de brevet CN 201 508 392 décrit une méthode de mesure de la résistance de la terre permettant d'éliminer une unique fréquence dans la tension neutre-terre. Cependant, les perturbations engendrées par les autres harmoniques ne sont pas éliminées et perturbent encore la mesure de la tension terre-neutre et par conséquent la détermination de la résistance de la terre.

La demande de brevet EP 1 482 317 décrit une méthode d'injection de courant de très grande amplitude de manière à améliorer le rapport signal sur bruit de la mesure de tension terre-neutre. Cependant, la méthode nécessite un environnement adapté pouvant supporter les forts pics de courants dans la terre et n'est ainsi applicable qu'en usine où les disjoncteurs tolèrent des fuites dix à mille fois plus importantes que les disjoncteurs d'un réseau domestique qui se déclenchent généralement pour un courant supérieur à 33 mA.

La demande de brevet EP 0 642 027 décrit une méthode s'appuyant sur une injection de tension entre la terre et le neutre. Cependant, la mise en oeuvre d'une telle méthode requiert un système de taille bien trop importante pour être intégré à un véhicule, et pour pouvoir imposer une tension au réseau.

L'invention se propose de fournir un système et un procédé d'estimation de la résistance de la terre embarquée sur un véhicule automobile en filtrant les perturbations dues au réseau d'alimentation et en distinguant la présence d'une capacité parasite située sur ce même réseau.

Selon un aspect de l'invention, il est proposé selon un mode de réalisation, un système sécurisé de charge d'une batterie d'un véhicule automobile à partir d'un réseau d'alimentation. Le système est embarqué sur le véhicule automobile et comprend des moyens d'injection d'impulsions de courant dans le réseau d'alimentation, des moyens de mesure de la tension entre la terre et le neutre du réseau d'alimentation.

Selon une caractéristique générale de l'invention, les moyens d'injection d'impulsions sont configurés pour que chaque injection d'impulsions de courant dans le réseau d'alimentation comprend l'injection d'une première impulsion positive suivie d'une seconde impulsion négative, la première et la seconde impulsions ayant une intensité égale en valeur absolue et étant séparées d'un intervalle suffisamment court pour qu'une capacité parasite couplée au réseau d'alimentation soit encore chargée lors de la seconde impulsion, et le système comprend des moyens de détermination de la résistance de terre à partir de l'amplitude des impulsions de courant et des tensions mesurées pour la première impulsion et la seconde impulsion de chaque injection d'impulsions.

Lors de la première impulsion positive, la capacité étant déchargée, la tension mesurée à l'issue de l'impulsion de courant s'exprimera à partir de l'expression :

$$V_1^m = R_t I_{inj} \left( 1 - e^{\frac{1}{R_t C_{parasite}}} \right) \qquad (1)$$

Où $V_1^m$ est la tension mesurée aux bornes du véhicule entre le neutre et la terre pour la première impulsion de courant injectée, $I_{inj}$ est l'intensité de l'impulsion de courant injectée dans le réseau d'alimentation, $R_t$ est la résistance entre le neutre et la terre du réseau d'alimentation, et $C_{parasite}$ est la capacité parasite connectée entre le neutre et la terre du réseau d'alimentation.

Lors de la seconde impulsion négative, immédiatement après la première impulsion, la capacité partant d'un état chargé, la tension mesurée n'est pas exactement l'opposé de la mesure précédente mais, après simplification, s'exprimera à partir de l'expression :

$$V_2^m = -R_t I_{inj} \left( 1 - e^{\frac{1}{R_t C_{parasite}}} \right)^2 \qquad (2)$$

Où $V_2^m$ est la tension mesurée aux bornes du véhicule entre le neutre et la terre pour la seconde impulsion de courant injectée, $I_{inj}$ est l'intensité de l'impulsion de courant injectée dans le réseau d'alimentation, $R_t$ est la résistance entre le neutre et la terre du réseau d'alimentation, et $C_{parasite}$ est la capacité parasite connectée entre le neutre et la terre du réseau d'alimentation

Chaque injection de deux impulsions consécutives est séparée de la précédente par plusieurs périodes électriques du réseau d'alimentation.

3

Pour retrouver les valeurs de la résistance de terre et de l'éventuelle capacité parasite couplée au réseau d'alimentation, on peut utiliser les formules suivantes :

$$R_t = \left| \frac{V_1^{m\,2}}{V_2^m I_{inj}} \right| \qquad\qquad (3)$$

$$C_{parasite} = - \frac{V_2^m \, t \, I_{inj}}{V_1^{m\,2} \log\left(1 - \frac{V_2^m}{V_1^m}\right)} \qquad\qquad (4)$$

Le système peut avantageusement comprendre des moyens de mesure de la fréquence du réseau d'alimentation, un filtre analogique pour filtrer à hautes fréquences les tensions mesurées, un filtre numérique pour filtrer à basses fréquences les tensions filtrées analogiquement, les moyens de détermination utilisant les tensions filtrées numériquement comme tensions mesurées, et le filtre numérique comprenant un filtre de moyenne déterminant une moyenne à partir de N mesures de tension espacées d'un intervalle de temps $T + \dfrac{T}{N}$, avec T la période du réseau d'alimentation déterminée par les moyens de mesure de la fréquence du réseau d'alimentation.

Cela permet de filtrer les perturbations d'un réseau d'alimentation non parfait. Ainsi, pour un réseau d'alimentation classique à 50 Hz et une moyenne effectuée à partir de 40 mesures, le filtre de moyenne déterminera une moyenne à partir de 40 mesures de tension réalisées avec un intervalle entre de 20,5 ms entre deux mesures.

Les hautes fréquences comprennent les fréquences supérieures à 2 kHz et notamment celles supérieures à 5 kHz. Les basse fréquences comprennent les fréquences inférieures à 5 kHz et notamment les fréquences comprises entre 50 Hz et 2 kHz.

Dans le cas d'un réseau d'alimentation ayant une fréquence de 60 Hz et d'une moyenne réalisée à partir de 40 mesures de tension, les mesures seront espacées d'un intervalle de temps de 17,1 ms en arrondissant à 0,1 ms près (T=16,7 ms).

De préférence, le filtre analogique est un filtre analogique du second ordre avec une fréquence de coupure comprise entre 800 Hz et 1,2 kHz, et préférentiellement de 1 kHz, et un facteur d'amortissement compris entre 0,6 et 0,8, et préférentiellement de 0,7, de manière à obtenir une atténuation de -20 dB à une fréquence de 3 kHz.

Le choix d'un filtre analogique ayant de telles caractéristiques permet de diminuer au maximum la durée des impulsions de courant injectées dans le réseau d'alimentation pour effectuer les mesures. La diminution de la durée des impulsions de courant permet d'augmenter l'amplitude des impulsions de courant et ainsi d'améliorer le rapport signal/bruit.

Avantageusement, compte-tenu de la bande passante du filtre analogique, pour que la tension mesurée soit bien l'image du courant des impulsions injectées, c'est-à-dire pour tenir compte du temps de réponse du filtre analogique, les impulsions de courant ont une durée au moins supérieure à 0,8 ms, et préférentiellement de 1 ms et une amplitude maximale comprise entre 18 mA et 22 mA, et préférentiellement de 20 mA.

Le système embarqué sécurisé peut avantageusement comprendre des moyens de commande de sécurité aptes à activer la charge de la batterie à partir du réseau d'alimentation seulement si la résistance de terre mesurée est inférieure à un seuil d'activation.

Ainsi si la terre du réseau d'alimentation présente une résistance supérieure au seuil d'activation, c'est-à-dire une résistance considérée comme au moins équivalente à la résistance d'un corps humain, le réseau d'alimentation n'est pas couplé à la batterie du véhicule et la charge n'est pas débutée. Ceci afin d'éviter un risque d'apparition d'un courant de toucher.

Pour cela, le seuil d'activation peut avantageusement correspondre à une valeur de résistance comprise entre 20 et 600 Ohms, et de préférence de 200 Ohms.

Selon un autre aspect, il est proposé, dans un mode de mise en oeuvre, un procédé de charge sécurisée de la batterie d'un véhicule automobile à partir d'un réseau d'alimentation estimant la résistance entre la terre et le neutre du réseau d'alimentation, dans lequel on réalise au moins une injection d'impulsions de courant dans le réseau d'alimentation, on réalise des mesures de tension entre la terre et le neutre du réseau d'alimentation en réponse à chaque impulsion, et on détermine la résistance de terre à partir des tensions mesurées.

Selon une caractéristique générale de l'invention, chaque injection d'impulsions de courant dans le réseau d'alimentation comprend l'injection d'une première impulsion positive suivie d'une seconde impulsion négative, la première et la seconde impulsions ayant une intensité égale en valeur absolue et étant séparées d'un intervalle suffisamment court pour qu'une capacité parasite couplée au réseau d'alimentation soit encore chargée lors de la seconde impulsion, et la détermination de la résistance de terre est réalisée à partir de l'amplitude des impulsions de courant et des tensions mesurées pour la première impulsion et la seconde impulsion de chaque injection d'impulsions.

Avantageusement, on mesure la fréquence du réseau d'alimentation, on filtre analogiquement à hautes fréquences les tensions mesurées pour chaque impulsion, on filtre numériquement à basses fréquences les tensions filtrées analogiquement, et la détermination de la résistance de terre est réalisée à partir des tensions filtrées numériquement, le filtrage numérique comprenant la détermination d'une moyenne à partir de N mesures de tension espacées d'un intervalle de temps $T + \dfrac{T}{N}$, avec T la période du réseau d'alimentation déterminée à partir de la mesure de la fréquence du réseau d'alimentation.

De préférence, le filtrage analogique comprend un filtrage au second ordre avec une fréquence de coupure comprise entre 800 Hz et 1,2 kHz, et préférentiellement de 1 kHz, et un facteur d'amortissement compris entre 0,6 et 0,8, et préférentiellement de 0,7.

Préférentiellement, les impulsions de courant ont une durée au moins supérieure à 0,8 ms, et préférentiellement de 1 ms et une amplitude maximale comprise entre 18 mA et 22 mA, et préférentiellement de 20 mA.

De préférence, la durée des impulsions de courant injectées dans le réseau d'alimentation correspond au moins à la période du réseau d'alimentation.

Avantageusement, on peut réaliser N=40 mesures de tension entre la terre et le neutre pour éliminer les 39 premières harmoniques du réseau d'alimentation.

De préférence, on couple le réseau d'alimentation à la batterie seulement si la résistance de terre mesurée est inférieure à un seuil d'activation.

D'autres avantages et caractéristiques de l'invention apparaîtront à l'examen de la description détaillée d'un mode de réalisation et d'un mode de mise en oeuvre, nullement limitatifs, et des dessins annexés, sur lesquels :

- la figure 1 présente de manière schématique un système embarqué sécurisé de charge d'une batterie d'un véhicule automobile selon un mode de réalisation ;
- la figure 2 présente un organigramme d'un procédé d'estimation de la résistance de terre d'un réseau d'alimentation selon un mode de mise en oeuvre ;
- la figure 3 présente un schéma électrique des tensions mises en oeuvre sur le réseau d'alimentation ;
- la figure 4 représente deux diagrammes de Bode en amplitude et en phase illustrant les actions des deux filtres du système de la figure 1.

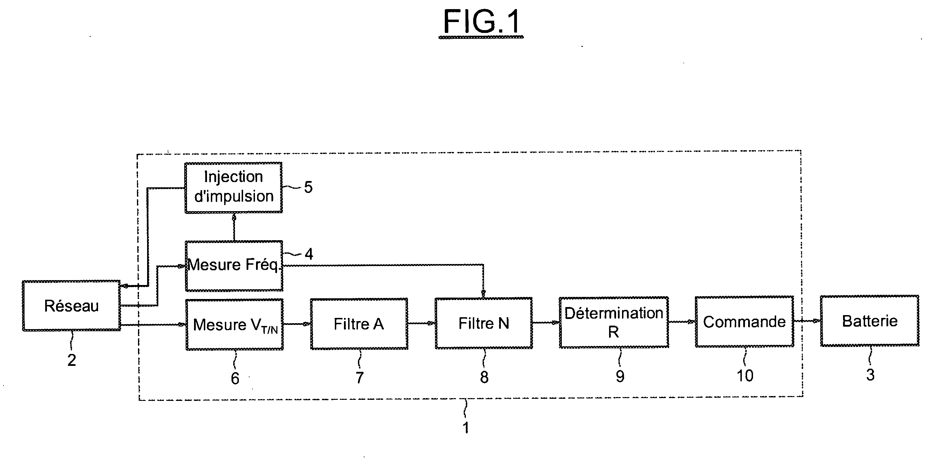

Sur la figure 1 est représenté un système sécurisé 1 selon un mode de réalisation de l'invention. Le système sécurisé 1 est embarqué à un bord d'un véhicule automobile et est destiné à être couplé entre un réseau d'alimentation 2 et une batterie 3 du véhicule automobile lors de la charge de la batterie.

Le système 1 comprend des moyens 4 de mesure de la fréquence du réseau d'alimentation 2 ainsi que des moyens 5 d'injection d'impulsions de courant dans le réseau d'alimentation 2. Les moyens 4 de mesure de fréquence sont couplés aux moyens 5 d'injection d'impulsions de courant de manière à délivrer aux moyens 5 d'injection d'impulsions de courant la valeur de la fréquence du réseau d'alimentation 2.

Les moyens 5 d'injection d'impulsions de courant ajustent la durée minimum des impulsions à la période T du signal du réseau d'alimentation 2. Dans le cas d'un réseau d'alimentation 2 à 50 Hz la durée minimale des impulsions de courant sera de 1 ms. A chaque injection, les moyens d'impulsions 5 délivrent une première impulsion positive suivie immédiatement après, d'une seconde impulsion négative. Les deux impulsions successives possèdent la même amplitude en valeur absolue mais sont de signe opposé.

Cette double impulsion de signes opposés permet, lors de la détermination de la résistance de terre, de s'affranchir de la valeur de l'éventuelle capacité parasite couplée au réseau d'alimentation 2 qui peut fausser la valeur de la résistance de terre.

Le système 1 comprend également des moyens de mesure 6 de la tension entre la terre et le neutre du réseau d'alimentation 2 qui réalisent une mesure de tension en réponse à chaque impulsion de courant injectée sur la terre et rebouclant par le neutre du réseau d'alimentation 2.

Les mesures de tensions réalisées à l'issue de la première et de la seconde impulsions successives donnent des valeurs strictement opposées lorsqu'il n'y a pas de capacité parasite couplée au réseau d'alimentation 2.

Lorsqu'il existe une capacité parasite, cette capacité déchargée avant la première impulsion, se charge lors de cette première impulsion, et n'a pas le temps de se décharger avant la seconde impulsion de courant de signe opposé. Dès lors les deux mesures de tensions résultant des deux impulsions de courant successives diffèrent et s'expriment à partir des équations (1) et (2) déjà mentionnées.

Pour retrouver les valeurs de la résistance de terre et de l'éventuelle capacité parasite couplée au réseau d'alimentation, on applique les formules (3) et (4) utilisant les mesures de tension de la première et de la seconde impulsion d'une injection.

Chaque injection d'une première et d'une seconde injection est séparée de la précédente par une pluralité de périodes électriques du réseau d'alimentation 2.

Les processeurs d'un véhicule automobile fonctionnent à une fréquence maximale de 10 kHz. On sait déjà d'après le théorème de Shannon qu'il sera tout à fait impossible de filtrer les perturbations dues à des fréquences supérieures à 5 kHz à l'aide d'un filtre numérique. Pour pouvoir s'affranchir des perturbations hautes fréquences dans les mesures de tension, le système 1 comprend un filtre analogique 7 couplé en sortie des moyens de mesure 6 de tension.

Le filtre analogique 7 utilisé dans ce mode de réalisation est un filtre analogique du second ordre avec une fréquence de coupure à 1 kHz et un facteur d'amortissement de 0,7 afin d'obtenir une atténuation de -20 dB à 3 kHz. Il est préférable d'utiliser un filtre possédant de telles caractéristiques plutôt qu'un filtre analogique quelconque, car il permet de diminuer au maximum la durée des impulsions de courant injectées et permet ainsi une augmentation de l'amplitude des impulsions de courant injectées.

Le système 1 comprend un filtre numérique 8 couplé à la sortie du filtre analogique 7. Le filtre numérique 8 permet d'éliminer les perturbations dues aux harmoniques du réseau d'alimentation 2 entre 50 Hz et 2 kHz. Au-delà de 2 kHz, le filtre analogique atténue déjà suffisamment les perturbations.

Compte-tenu de la bande-passante du filtre analogique, pour que la tension mesurée soit bien l'image du courant des impulsions injectées, il est préférable que la durée minimale des impulsions de courant injectées corresponde au moins au temps de réponse du filtre analogique pour que le filtrage à hautes fréquences soit efficace. Pour cela, la durée des impulsions injectées doit au moins correspondre à une période du signal du réseau d'alimentation 2. Ainsi, pour un réseau d'alimentation 3 de fréquence 50 Hz, la durée minimale des impulsions de courant injectées doit être de 1 ms.

Une durée plus longue d'impulsion de courant obligerait à diminuer l'amplitude des impulsions de courant pour ne pas faire disjoncter le système. Or, il est important d'émettre des impulsions d'amplitude la plus importante possible car elles génèrent en réponse des tensions plus importantes et donc plus visibles par rapport au bruit.

Dans le cas d'un réseau d'alimentation 2 à 50 Hz, pour une impulsion de 1 ms, l'amplitude des impulsions de courant peut atteindre 20 mA au maximum sans qu'il y ait de risque que le système disjoncte. Une impulsion de 20 mA sur une résistance de 50 Ohms engendrera une tension de 1 V noyée dans des bruits de 50 V (sommes des bruits aux harmoniques du réseau d'alimentation). De façon numérique, il faut donc éliminer au maximum les harmoniques du réseau d'alimentation 2.

Pour ce faire le filtre numérique 8 comprend un filtre de moyenne qui présente l'avantage d'atténuer à l'infini les fréquences ciblées. Par exemple, enregistrer deux points séparés de 10 ms et en faire la moyenne permet d'éliminer totalement le 50 Hz.

Le filtre numérique est couplé aux moyens 4 de mesure de la fréquence du réseau d'alimentation 2 afin de recevoir l'information relative à la période électrique T du réseau d'alimentation 2.

En enregistrant quarante points de mesures équirépartis sur les 20 ms de période électrique, chaque point de mesure comprenant une mesure de tension pour la première impulsion et une mesure de tension pour la seconde impulsion, il est possible d'éliminer jusqu'à la 39e harmonique du réseau, soit jusqu'à la fréquence 1950 Hz sur un réseau d'alimentation 2 fonctionnant à 50 Hz.

Cependant réaliser des injections de deux impulsions successives de 1 ms chacune, chaque double impulsion étant espacée de la précédente de 500 $\mu$s est impossible avec une amplitude d'impulsion de 20 mA.

Il est fait ici référence à une injection d'une première impulsion suivie immédiatement après d'une seconde impulsion de signe opposé par l'expression « double impulsion ».

Pour pouvoir néanmoins effectuer cette moyenne, le système réalise des mesures de double impulsion en se décalant à chaque nouvelle mesure de double impulsion d'une période électrique T du signal du réseau d'alimentation 2 en plus du décalage de mesure d égal à d=T/N avec N le nombre de mesures à réaliser dans une période électrique T de signal.

Ainsi, dans le cas d'un réseau d'alimentation à 50 Hz et d'une moyenne réalisée à partir de 40 mesures, la première double mesure de tension en réponse à une première double impulsion serait réalisée à un instant $t = 0$, et la seconde double mesure de tension en réponse à une seconde double impulsion à instant ultérieur $t = 20,5ms$, l'intervalle correspondant à l'addition d'une période électrique T=1/50=20ms avec un décalage de mesure d=20/40=0,5ms. Cette seconde double mesure serait identique à une double mesure effectuée seulement 500 $\mu$s après la première puisque le signal de bruit est périodique avec une période T=20ms.

En faisant ainsi quarante acquisitions de doubles mesures de tension espacées de 20,5 ms et en faisant la moyenne des premières tensions mesurées pour chaque double impulsion (moyenne positive), d'une part, et la moyenne des secondes tensions mesurées pour chaque double impulsion (moyenne négative), d'autre part, sur ces quarante doubles mesures, le filtre numérique 8 élimine les perturbations aux harmoniques du réseau et permet de retrouver la composante continue due aux impulsions de courant injectées dans le réseau d'alimentation 2.

La tension moyenne ainsi filtrée numériquement est délivrée à des moyens de détermination 9 de la résistance $R_t$ entre la terre et le neutre du réseau d'alimentation 2. La valeur de la résistance de la terre est déterminée à partir de la valeur absolue du rapport entre le carré de ladite moyenne des premières tensions et le produit de ladite moyennes des secondes tensions par l'amplitude des impulsions de courant injectées dans le réseau d'alimentation 2.

Le système 1 comprend des moyens de commande de sécurité 10 couplés en entrée aux moyens de détermination 9 et en sortie à la batterie 3 du véhicule automobile. Si la valeur de la résistance de terre déterminée est inférieure à une valeur seuil de 500 Ohms, le couplage est réalisé avec la batterie 3 du véhicule automobile, et la charge peut démarrer. Sinon, la batterie 3 n'est pas couplée électriquement au réseau d'alimentation 2 et la charge n'a pas lieu.

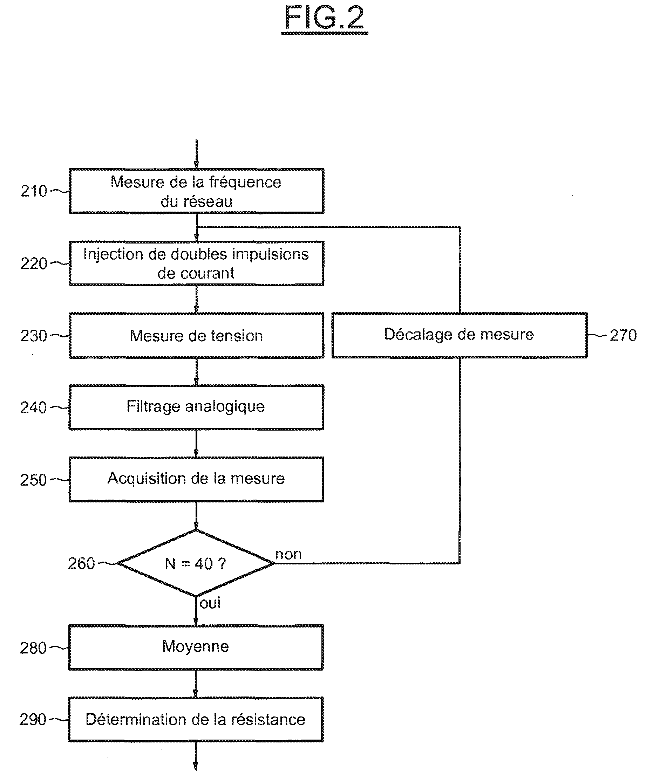

La figure 2 présente un organigramme d'un procédé d'estimation de la résistance entre la terre et le neutre d'un réseau d'alimentation utilisé pour charger une batterie d'un véhicule automobile selon un mode de mise en oeuvre.

Dans une première étape 210, on mesure la fréquence du réseau d'alimentation 2 couplé au véhicule automobile 100 pour recharger la batterie 3 du véhicule automobile.

Dans une étape suivante 220, on injecte des doubles impulsions de courant dans le réseau d'alimentation 2, chaque double impulsion comprenant une première impulsion de courant suivi d'une seconde impulsion de courant de signe opposé. La durée des impulsions dépend du filtre analogique 7 choisi qui dépend lui-même de la période du réseau d'alimentation 2.

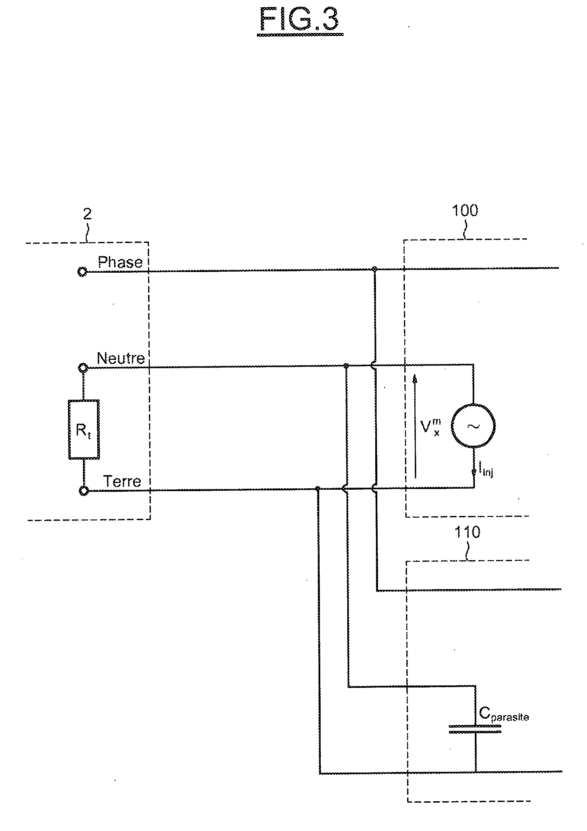

Puis, dans une étape 230, on réalise des mesures de tension $V_x^m$ entre la terre, *Terre,* et le neutre, *Neutre,* du réseau d'alimentation 2 à l'issue de chacune des première et seconde impulsions de courant $I_{inj}$ injectées. La figure 3 présente un schéma électrique des tensions mises en oeuvre sur le réseau d'alimentation.

Dans une étape suivante 240, on filtre analogiquement à hautes fréquences chaque tension mesurée $V_x^m$.

On acquière ensuite la mesure $V_x^m$, dans une étape 250, puis on teste le nombre de mesures $V_x^m$ effectuées dans une étape 260. Si on n'a pas encore effectué 40 doubles mesures de tension, on recommence une double mesure à partir d'une nouvelle injection de double impulsion de courant à l'étape 220 sur une période électrique T suivante, en ayant décalé, dans une étape 270, le moment de la double mesure d'un temps de décalage d=T/N, soit dans le cas d'un réseau d'alimentation à 50 Hz, un temps d=0,5 ms.

Une fois la 40e double mesure effectuée, on filtre numériquement à basses fréquences, dans une étape suivante 280, en réalisant la moyenne des quarante premières tensions mesurées $V_1^m$ d'une part et la moyenne des quarante seconde tension mesurées $V_2^m$ d'autre part, et on détermine finalement, dans une étape 290, la résistance $R_t$ entre la terre, *Terre*, et le neutre, *Neutre,* à partir de la valeur absolue du rapport entre le carré de ladite moyenne des premières tensions et le produit de ladite moyenne des secondes tensions par l'amplitude des impulsions de courant selon l'expression (3). Cette détermination permet de s'affranchir de la valeur de la capacité parasite $C_{parasite}$ couplée entre la terre, *Terre*, et le neutre, *Neutre,* du réseau d'alimentation 2 via le couplage d'un autre véhicule automobile 110 au réseau d'alimentation 110.

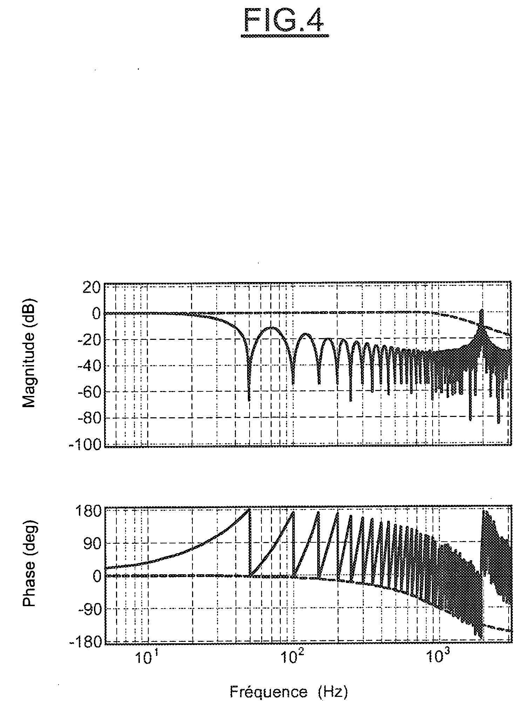

La figure 4 présente sur deux diagrammes de Bode l'amplitude et la phase des actions du filtre analogique en tirets et du filtre numérique en trait plein pour une fréquence du réseau d'alimentation de 50 Hz.

Le système sécurisé 1 est adapté aux contraintes de l'automobile et permet de vérifier la qualité de la terre d'un réseau, notamment d'un réseau domestique avant d'autoriser le début de la charge de la batterie du véhicule automobile à bord duquel le système sécurisé est embarqué, et ce même lorsqu'un élément perturbateur, tel qu'un autre chargeur, introduit des éléments capacitifs sur le réseau d'alimentation.

**Revendications**

1. Système (1) sécurisé de charge d'une batterie (3) d'un véhicule automobile à partir d'un réseau d'alimentation (2), le système (1) étant embarqué sur le véhicule automobile et comprenant des moyens d'injection (5) d'impulsions de courant dans le réseau d'alimentation (2), des moyens de mesure (6) de la tension entre la terre et le neutre du réseau d'alimentation (2), **caractérisé en ce que** les moyens d'injection d'impulsions sont configurés pour que chaque injection d'impulsions de courant dans le réseau d'alimentation (2) comprenne l'injection d'une première impulsion positive suivie d'une seconde impulsion négative, la première et la seconde impulsions ayant une intensité égale en valeur absolue et étant séparées d'un intervalle suffisamment court pour qu'une capacité parasite couplée au réseau d'alimentation (2) soit encore chargée lors de la seconde impulsion, et le système comprend des moyens de détermination (9) de la résistance de terre à partir de l'amplitude des impulsions de courant et des tensions mesurées pour la première impulsion et la seconde impulsion de chaque injection d'impulsions.

2. Système (1) selon la revendication 1, comprenant des moyens de mesure (4) de la fréquence du réseau d'alimentation (2), un filtre analogique (7) pour filtrer à hautes fréquences les tensions mesurées, un filtre numérique (8) pour filtrer à basses fréquences les tensions filtrées analogiquement, les moyens de détermination (9) utilisant les tensions filtrées numériquement comme tensions mesurées, et le filtre numérique (8) comprenant un filtre de moyenne déterminant une moyenne à partir de N mesures de tension espacées d'un intervalle de temps $T + \dfrac{T}{N}$, avec T la période du réseau d'alimentation (2) déterminée par les moyens de mesure (4) de la fréquence du réseau d'alimentation (2).

3.  Système (1) selon la revendication 2, dans lequel le filtre analogique (7) est un filtre analogique du second ordre avec une fréquence de coupure comprise entre 800 Hz et 1,2 kHz, et préférentiellement de 1 kHz, et un facteur d'amortissement compris entre 0,6 et 0,8, et préférentiellement de 0,7.

4.  Système (1) selon la revendication 3, dans lequel les impulsions de courant ont une durée au moins supérieure à 0,8 ms, et préférentiellement de 1 ms et une amplitude maximale comprise entre 18 mA et 22 mA, et préférentiellement de 20 mA.

5.  Système (1) selon l'une quelconque des revendications 1 à 4, comprenant des moyens de commande (10) de sécurité aptes à activer la charge de la batterie (3) à partir du réseau d'alimentation (2) seulement si la résistance de terre mesurée est inférieure à un seuil d'activation.

6.  Système (1) selon la revendication 5, dans lequel le seuil d'activation correspond à une valeur de résistance comprise entre 20 et 600 Ohms, et correspond de préférence à 200 ohms.

7.  Procédé de charge sécurisée d'une batterie (3) d'un véhicule automobile à partir d'un réseau d'alimentation (2) estimant la résistance entre la terre et le neutre du réseau d'alimentation (2), dans lequel on réalise au moins une injection d'impulsions de courant dans le réseau d'alimentation (2), on réalise des mesures de tension entre la terre et le neutre du réseau d'alimentation (2) en réponse à chaque impulsion, et on détermine la résistance de terre à partir des tensions mesurées, **caractérisé en ce que** chaque injection d'impulsions de courant dans le réseau d'alimentation (2) comprend l'injection d'une première impulsion positive suivie d'une seconde impulsion négative, la première et la seconde impulsions ayant une intensité égale en valeur absolue et étant séparées d'un intervalle suffisamment court pour qu'une capacité parasite couplée au réseau d'alimentation (2) soit encore chargée lors de la seconde impulsion, et la détermination de la résistance de terre est réalisée à partir de l'amplitude des impulsions de courant et des tensions mesurées pour la première impulsion et la seconde impulsion de chaque injection d'impulsions.

8.  Procédé selon la revendication 7, dans lequel on mesure la fréquence du réseau d'alimentation (2), on filtre analogiquement à hautes fréquences les tensions mesurées pour chaque impulsion, on filtre numériquement à basses fréquences les tensions filtrées analogiquement, et la détermination de la résistance de terre est réalisée à partir des tensions filtrées numériquement, le filtrage numérique comprenant la détermination d'une moyenne à partir de N mesures de tension espacées d'un intervalle de temps $T + \dfrac{T}{N}$, avec T la période du réseau d'alimentation (2) déterminée à partir de la mesure de la fréquence du réseau d'alimentation (2).

9.  Procédé selon la revendication 8, dans lequel le filtrage analogique comprend un filtrage au second ordre avec une fréquence de coupure comprise entre 800 Hz et 1,2 kHz, et préférentiellement de 1 kHz, et un facteur d'amortissement compris entre 0,6 et 0,8, et préférentiellement de 0,7.

10. Procédé selon la revendication 9, dans lequel les impulsions de courant ont une durée au moins supérieure à 0,8 ms, et préférentiellement de 1 ms et une amplitude maximale comprise entre 18 mA et 22 mA, et préférentiellement de 20 mA.

11. Procédé selon l'une quelconque des revendications 7 à 10, dans lequel la durée des impulsions de courant injectées dans le réseau d'alimentation (2) correspond au moins à la période du réseau d'alimentation (2).

12. Procédé selon l'une quelconque des revendications 7 à 11, dans lequel on couple le réseau d'alimentation (2) à la batterie (3) seulement si la résistance de terre mesurée est inférieure à un seuil d'activation.

**Patentansprüche**

1. Gesichertes Ladesystem (1) einer Batterie (3) eines Kraftfahrzeugs ausgehend von einem Versorgungsnetzwerk (2), wobei das System (1) auf dem Kraftfahrzeug mitgeführt ist und Mittel zum Injizieren (5) von Stromimpulsen in das Versorgungsnetzwerk (2), Mittel zum Messen (6) der Spannung zwischen der Erdung und dem Nullleiter des Versorgungsnetzwerks (2) umfasst, **dadurch gekennzeichnet, dass** die Mittel zum Injizieren von Impulsen konfiguriert sind, so dass jede Injektion von Stromimpulsen in das Versorgungsnetzwerk (2) die Injektion eines ersten positiven Impulses gefolgt von einem zweiten negativen Impuls umfasst, wobei der erste und der zweite Impuls eine Stärke haben, die im Absolutwert gleich ist, und durch ein Intervall getrennt sind, das ausreichend kurz ist, damit eine parasitäre Kapazität, die mit dem Versorgungsnetzwerk (2) gekoppelt ist, noch bei dem zweiten Impuls geladen wird, und das System Mittel zum Bestimmen (9) des Erdungswiderstands ausgehend von der Amplitude der Stromimpulse und den für den ersten Impuls und den zweiten Impuls jeder Injektion von Impulsen gemessenen Spannungen umfasst.

2. System (1) nach Anspruch 1, das Mittel zum Messen (4) der Frequenz des Versorgungsnetzwerks (2), ein analoges Filter (7) zum Filtern mit hohen Frequenzen der gemessenen Spannungen, ein digitales Filter (8) zum Filtern mit niedrigen Frequenzen der analog gefilterten Spannungen, Mittel zum Bestimmen (9), die die digital gefilterten Spannungen als gemessene Spannungen verwenden, umfasst und wobei das digitale Filter (8) ein Mittelwertfilter umfasst, das einen Mittelwert ausgehend von N Spannungsmessungen bestimmt, die um ein Zeitintervall $T + \dfrac{T}{N}$ beabstandet sind, wobei T die Periode des Versorgungsnetzwerks (2) ist, die durch die Mittel zum Messen (4) der Frequenz des Versorgungsnetzwerks (2) bestimmt wird.

3. System (1) nach Anspruch 2, wobei das analoge Filter (7) ein analoges Filter zweiter Ordnung mit einer Abschaltfrequenz zwischen 800 Hz und 1,2 kHz und vorzugsweise 1 kHz und einem Dämpfungsfaktor zwischen 0,6 und 0,8 und vorzugsweise 0,7 ist.

4. System (1) nach Anspruch 3, wobei die Stromimpulse eine Dauer von mindestens größer als 0,8 ms und vorzugsweise 1 ms und eine maximale Amplitude zwischen 18 mA und 22 mA und vorzugsweise 20 mA haben.

5. System (1) nach einem der Ansprüche 1 bis 4, das Sicherheitssteuermittel (10) umfasst, die geeignet sind, um das Laden der Batterie (3) ausgehend von dem Versorgungsnetzwerk (2) nur zu aktivieren, falls der gemessene Erdungswiderstand niedriger ist als ein Aktivierungsschwellenwert.

6. System (1) nach Anspruch 5, wobei der Aktivierungsschwellenwert einem Widerstandswert zwischen 20 und 600 Ohm und vorzugsweise 200 Ohm entspricht.

7. Verfahren zur gesicherten Aufladung einer Batterie (3) eines Kraftfahrzeugs ausgehend von einem Versorgungsnetzwerk (2), das den Widerstand zwischen der Erdung und dem Nullleiter des Versorgungsnetzwerks (2) schätzt, wobei man mindestens eine Injektion von Stromimpulsen in das Versorgungsnetzwerk (2) ausführt, man Spannungsmessungen zwischen der Erdung und dem Nullleiter des Versorgungsnetzwerks (2) als Reaktion auf jeden Impuls ausführt, und man den Erdungswiderstand ausgehend von den gemessenen Spannungen bestimmt, **dadurch gekennzeichnet, dass** jede Injektion von Stromimpulsen in das Versorgungsnetzwerk (2) das Injizieren eines ersten positiven Impulses gefolgt von einem zweiten negativen Impuls umfasst, wobei der erste und der zweite Impuls eine Stärke haben, die im Absolutwert gleich ist, und durch ein Intervall getrennt sind, das ausreichend kurz ist, damit eine parasitäre Kapazität, die mit dem Versorgungsnetzwerk (2) gekoppelt ist, noch bei dem zweiten Impuls geladen wird, und das Bestimmen des Erdungswiderstands ausgehend von der Amplitude der Stromimpulse und den für den ersten Impuls und den zweiten Impuls jeder Injektion von Impulsen gemessenen Spannungen ausgeführt wird.

8. Verfahren nach Anspruch 7, wobei man die Frequenz des Versorgungsnetzwerks (2) misst, die gemessenen Spannungen für jeden Impuls analog mit hohen Frequenzen filtert, man die analog gefilterten Spannungen mit niedrigen Spannungen digital filtert, und das Bestimmen des Erdungswiderstands ausgehend von den digital gefilterten Spannungen ausgeführt wird, wobei das digitale Filtern das Bestimmen eines Mittelwerts ausgehend von N Spannungsmessungen umfasst, die um ein Zeitintervall $T + \dfrac{T}{N}$ beabstandet sind, wobei T die Periode des Versorgungsnetzwerks (2) ist, die ausgehend von der Messung der Frequenz des Versorgungsnetzwerks (2) bestimmt wird.

9. Verfahren nach Anspruch 8, wobei das analoge Filtern ein Filtern zweiter Ordnung mit einer Abschaltfrequenz zwischen 800 Hz und 1,2 kHz und vorzugsweise 1 kHz und einem Dämpfungsfaktor zwischen 0,6 und 0,8 und vorzugsweise 0,7 umfasst.

10. Verfahren nach Anspruch 9, wobei die Stromimpulse eine Dauer von mindestens größer als 0,8 ms und vorzugsweise 1 ms und eine maximale Amplitude zwischen 18 mA und 22 mA und vorzugsweise 20 mA haben.

11. Verfahren nach einem der Ansprüche 7 bis 10, wobei die Dauer der Stromimpulse, die in das Versorgungsnetzwerk (2) injiziert werden, mindestens der Periode des Versorgungsnetzwerks (2) entspricht.

12. Verfahren nach einem der Ansprüche 7 bis 11, wobei man das Versorgungsnetzwerk (2) mit der Batterie (3) nur koppelt, falls der gemessene Erdungswiderstand niedriger ist als ein Aktivierungsschwellenwert.

**Claims**

1. Secure system (1) for charging of a battery (3) of a motor vehicle from a supply network (2), the system (1) being installed in the motor vehicle and comprising means (5) for injecting current pulses into the supply network (2), and means (6) for measuring the voltage between the ground and the neutral of the supply network (2), **characterized in that** the pulse injection means are configured so that each injection of current pulses into the supply network (2) comprises the injection of a positive first pulse followed by a negative second pulse, the first and second pulses having an equal strength in absolute value and being separated by an interval which is sufficiently short for a parasitic capacitance coupled to the supply network (2) to be still charged during the second pulse, and the system comprises means (9) of determining the ground resistance on the basis of the amplitude of the current pulses and voltages measured for the first pulse and the second pulse of each pulse injection.

2. System (1) according to Claim 1, comprising means (4) for measuring the frequency of the supply network (2), an analog filter (7) for filtering the measured voltages at high frequencies, a digital filter (8) for filtering the analog-filtered voltages at low frequencies, the determination means (9) using the digitally filtered voltages as measured voltages, and the digital filter (8) comprising an average filter determining an average on the basis of N voltage measurements separated by a time interval $T + \dfrac{T}{N}$, with T being the period of the supply network (2) as determined by the means (4) for measuring the frequency of the supply network (2).

3. System (1) according to Claim 2, wherein the analog filter (7) is a second-order analog filter with a cutoff frequency of between 800 Hz and 1.2 kHz, and preferably 1 kHz, and a damping factor of between 0.6 and 0.8, and preferably 0.7.

4. System (1) according to Claim 3, wherein the current pulses have a duration at least greater than 0.8 ms, and preferably 1 ms, and a maximum amplitude of between 18 mA and 22 mA, and preferably 20 mA.

5. System (1) according to any one of Claims 1 to 4, comprising safety control means (10) adapted to activate the charging of the battery (3) from the supply network (2) only if the measured ground resistance is less than an activation threshold.

6. System (1) according to Claim 5, wherein the activation threshold corresponds to a resistance value of between 20 and 600 ohms, and preferably corresponds to 200 ohms.

7. Method for secure charging of a battery (3) of a motor vehicle from a supply network (2), estimating the resistance between the ground and the neutral of the supply network (2), wherein at least one injection of current pulses into the supply network (2) is carried out, measurements of voltage between the ground and the neutral of the supply network (2) in response to each pulse are taken, and the ground resistance is determined on the basis of the voltages measured, **characterized in that** each injection of current pulses into the supply network (2) comprises the injection of a positive first pulse followed by a negative second pulse, the first and second pulses having an equal strength in absolute value and being separated by an interval which is sufficiently short for a parasitic capacitance coupled to the supply network (2) to be still charged during the second pulse, and the determination of the ground resistance is carried out on the basis of the amplitude of the current pulses and the voltages measured for the first pulse and the second pulse of each pulse injection.

8. Method according to Claim 7, wherein the frequency of the supply network (2) is measured, the voltages measured for each pulse are analog-filtered at high frequencies, the analog-filtered voltages are digitally filtered at low frequencies, and the determination of the ground resistance is carried out on the basis of the digitally filtered voltages, the digital filtering comprising the determination of an average on the basis of N voltage measurements separated by a time interval $T + \dfrac{T}{N}$, with T being the period of the supply network (2) as determined on the basis of the measurement of the frequency of the supply network (2).

9. Method according to Claim 8, wherein the analog filtering comprises second-order filtering with a cutoff frequency of between 800 Hz and 1.2 kHz, and preferably 1 kHz, and a damping factor of between 0.6 and 0.8, and preferably 0.7.

10. Method according to Claim 9, wherein the current pulses have a duration at least greater than 0.8 ms, and preferably 1 ms, and a maximum amplitude of between 18 mA and 22 mA, and preferably 20 mA.

11. Method according to any one of Claims 7 to 10, wherein the duration of the current pulses injected into the supply network (2) corresponds at least to the period of the supply network (2).

12. Method according to any one of Claims 7 to 11, wherein the supply network (2) is coupled to the battery (3) only if the measured ground resistance is less than an activation threshold.

# FIG.1

EP 2 849 964 B1

## FIG.2

```
                          │
                          ▼
        ┌─────────────────────────────────┐
210 ──  │  Mesure de la fréquence          │
        │         du réseau                │
        └─────────────────────────────────┘
                          │
                          ▼  ◄─────────────────────────┐
        ┌─────────────────────────────────┐            │
220 ──  │  Injection de doubles impulsions │            │
        │         de courant               │            │
        └─────────────────────────────────┘            │
                          │                             │
                          ▼                             │
        ┌─────────────────────┐   ┌──────────────────────────┐
230 ──  │  Mesure de tension  │   │   Décalage de mesure     │ ── 270
        └─────────────────────┘   └──────────────────────────┘
                          │                             ▲
                          ▼                             │
        ┌─────────────────────┐                         │
240 ──  │ Filtrage analogique │                         │
        └─────────────────────┘                         │
                          │                             │
                          ▼                             │
        ┌─────────────────────────┐                     │
250 ──  │ Acquisition de la mesure│                     │
        └─────────────────────────┘                     │
                          │                             │
                          ▼             non             │
              ◇───────────────────◇ ──────────────────┘
360 ──        ◇      N = 40 ?      ◇
              ◇───────────────────◇
                          │ oui
                          ▼
        ┌─────────────────────┐
280 ──  │      Moyenne        │
        └─────────────────────┘
                          │
                          ▼
        ┌──────────────────────────────┐
290 ──  │ Détermination de la résistance│
        └──────────────────────────────┘
                          │
                          ▼
```

# FIG.3

# FIG.4

**EP 2 849 964 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 201508392
- EP 1482317 A
- EP 0642027 A